(19) Europäisches Patentamt
European Patent Office
Office européen des brevets

(11) Veröffentlichungsnummer: **0 033 015**
**B1**

(12) **EUROPÄISCHE PATENTSCHRIFT**

(45) Veröffentlichungstag der Patentschrift: **04.05.83**

(51) Int. Cl.³: **C 08 G 73/10**, C 07 D 471/06, G 03 G 5/07, H 01 B 1/12, H 01 L 29/28

(21) Anmeldenummer: **80108212.4**

(22) Anmeldetag: **24.12.80**

(54) **Elektrisch leitende cyclische Polyimide.**

(30) Priorität: **04.01.80 DE 3000168**

(43) Veröffentlichungstag der Anmeldung: **05.08.81 Patentblatt 81/31**

(45) Bekanntmachung des Hinweises auf die Patenterteilung: **04.05.83 Patentblatt 83/18**

(84) Benannte Vertragsstaaten: **DE FR GB IT**

(56) Entgegenhaltungen:
**AT-B-340 685**
**DE-A-1 445 769**
**DE-A-1 770 796**
**DE-A-1 800 273**
**DE-A-2 904 801**
**US-A-3 812 082**

(73) Patentinhaber: **BAYER AG, Zentralbereich Patente, Marken und Lizenzen, D-5090 Leverkusen 1, Bayerwerk (DE)**

(72) Erfinder: **Hocker, Jürgen, Dr., Eichenweg 6, D-5060 Bergisch-Gladbach 2 (DE)**
Erfinder: **Merten, Rudolf, Dr., Berta-von-Suttner-Strasse 55, D-5090 Leverkusen 1 (DE)**
Erfinder: **Fitzky, Hans Georg, Dr., Adolf-Kolping-Strasse 7, D-5068 Odenthal (DE)**



Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Elektrisch leitende cyclische Polyimide

Gegenstand der Erfindung sind cyclische Polyimide der Formel I

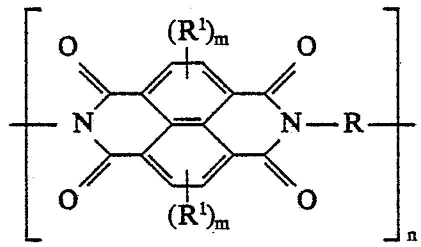

(I)

worin

R ein zweiwertiger aliphatischer Rest ist, der eine Elektronendonatorfunktion enthält,
$R^1$ Wasserstoff, Halogen, $-SO_3H$, $-CN$, $-COOR^2$, $-N(R^3)_2$, $-OR^4$, $-NO_2$;
$R^2$, $R^3$, $R^4$ Wasserstoff oder $C_1-C_6$-Alkyl, und
n eine ganze Zahl von 2 bis 1000, bevorzugt 10 bis 500, insbesondere 10 bis 200, und
m 1 oder 2 bedeuten.

Der Rest R ist insbesondere ein gesättigter oder olefinisch ungesättigter aliphatischer Rest mit bis zu 12 Kohlenstoffatomen, welcher mindestens ein Heteroatom wie Sauerstoff, Schwefel oder $NR^2$ ($R^2$ wie oben definiert) in der Hauptkette oder in einer Seitenkette enthalten muß.

Besonders bevorzugt sind die cyclischen Polyimide der Formel I, in denen $R^1$ Wasserstoff ist, und in denen der Rest R von einem Alkylentriamin oder einem Oxaalkylendiamin der Formeln II bzw. III abgeleitet ist.

$$NH_2-\left[(CH_2)_p-\underset{\displaystyle R^5}{\underset{|}{N}}-\right]_{1-5}(CH_2)_p-NH_2 \qquad (II)$$

$R^5$ = H, Alkyl, $CR^2O$
p = 1–4

$$NH_2-(CH_2)_r-O-[(CH_2)_r-O]_o-(CH_2)_r-NH_2 \qquad (III)$$

r = 1–4
o = 0–2

Besonders bevorzugt sind die Umsetzungprodukte von Naphthalin-1,4,5,8-tetracarbonsäuredianhydrid mit Diethylentriamin, Triethylentetramin, Tetraethylenpentamin bzw. deren N-Methylderivate, die jedoch zwei freie endständige Aminogruppen enthalten müssen, sowie 1,4-Bis-(3-aminopropyl)-piperazin.

Die erfindungsgemäßen cyclischen Imide sind filmbildende Polymere, sie besitzen z. T. elektrische Leitfähigkeiten von mehr als $10^{-8}\Omega^{-1}\,cm^{-1}$, die beim Belichten mit einer Xenon-Hochdrucklampe um über 2 Zehnerpotenzen ansteigen können, so daß sie als elektrische Halbleiter und als Photoleiter eingesetzt werden können.

Die erfindungsgemäßen polymeren cyclischen Imide können nach prinzipiell bekannten Methoden hergestellt werden. Man kann beispielsweise Naphthalin-1,4,5,8-tetracarbonsäuredianhydrid oder Naphthalin-1,4,5,8-tetracarbonsäure, deren aromatische Ringe bereits durch die Reste $R^1$ substituiert sein können, mit einem den Rest R einschließlich der beiden Stickstoffatome liefernden Diamin umsetzen. Diese Umsetzung kann in einem organischen Lösungsmittel, beispielsweise Dimethylformamid, N-Methylpyrrolidon, Pyridin, Ameisensäure, Essigsäure, Dimethylsulfoxid, Dimethylacetamid oder Gemischen daraus ablaufen. Die Reaktion ist auch in der Schmelze ohne Lösungsmittel möglich. Das bei der Umsetzung gebildete Wasser kann entweder vom Lösungsmittel aufgenommen werden oder destillativ abgetrennt werden. Die Reaktion kann auch in zwei Stufen ausgeführt werden, durch Umsetzung der Dicarbonsäure und des Diamins in erster Stufe zur Amidsäure und in zweiter Stufe zum Polyimid. Bei der Umsetzung verwendet man im allgemeinen etwa stöchiometrische Mengen der Reaktanden, die Umsetzung beginnt meist bei Temperaturen von 0 bis 80°C. Es ist empfehlenswert, nach Beendigung der Hauptreaktion das Reaktionsgemisch noch einige Zeit bei Temperaturen von 80 bis 120°C zu halten, um die Reaktion zu vervollständigen. Bei unvollständiger Reaktion kann auch ein Teil der ursprünglich vorhandenen Carbonsäure- bzw. Carbonsäureanhydridgruppen als offenkettige Amidsäuregruppen vorliegen.

Arbeitet man in Gegenwart organischer Säuren wie Ameisensäure oder Essigsäure als Lösungsmittel, so erhält man, falls die aliphatische Kette R eine NH-Funktion enthält, die entsprechenden Acylierungsprodukte. Wenn R eine $NR^2$-Funktion enthält, kann man die erhaltenen cyclischen Polyimide auch in die Ammoniumsalze anorganischer oder organischer Säuren umwandeln. Diese Derivate sind wasserlöslich und können durch Zusatz von Basen gefällt werden.

Die erfindungsgemäßen Polyimide können z. B. als halbleitende bzw. photoleitende Polymere, insbesondere als Lacke z. B. in der Reproduktionstechnik, als Heizlacke, für gedruckte Schaltungen bzw. als optoelektronische Bauelemente Verwendung finden.

### Beispiel 1, Methode A

Zu einer Suspension aus 100 Gew.-Teilen Dimethylformamid, 50 Gew.-Teilen Pyridin und 10,72 Gew.-Teilen Naphthalintetracarbonsäuredianhydrid tropft man bei Raumtemperatur unter Stickstoff eine Lösung von 4,15 Gew.-Teilen Bis-(2-aminoethyl)-amin in 50 Gew.-Teile Pyridin. Man rührt 4 Stunden bei 100°C, kühlt und saugt ab. Nach Trocknen bei 50°C erhält man 10 Gew.-Teile des Polymeren IV.

Analyse

| | | | | |
|---|---|---|---|---|
| Ber. | C 64,48 | H 3,91 | N 12,53 | O 19,08 |
| Gef. | C 63,2 | H 4,4 | N 11,9 | O 19,1 |

IR (KBr): 1700, 1655 $cm^{-1}$ ($\nu_{co}$)

NMR ($CD_3COOD$): $\delta = 8{,}83$ ppm (4H), 4,8 ppm (4H), 3,9 ppm (4H)

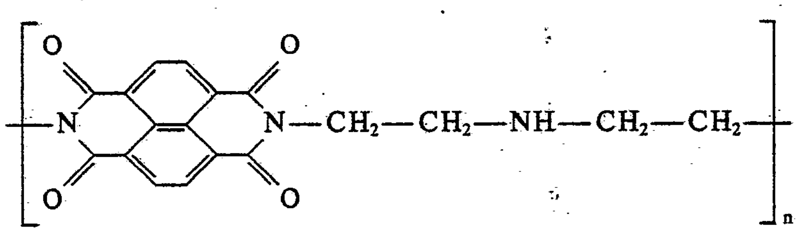

(IV)

Spez. Leitfähigkeit: $4{,}4 \cdot 10^{-3} \Omega^{-1} cm^{-1}$ (Mikrowellenmessung bei 9 GHz).

### Beispiel 1, Methode B

Zu einer Suspension aus 10,72 Gew.-Teilen Naphthalintetracarbonsäuredianhydrid in 150 Vol.-Teilen Essigsäure tropft man bei Raumtemperatur unter Stickstoff eine Lösung von 4,15 Gew.-Teilen Bis-(2-aminoethyl)-amin in 50 Vol.-Teile Pyridin und erhitzt 5 Stunden auf 100°C. Nach Abkühlen auf Raumtemperatur saugt man von 9,7 Gew.-Teilen eines Polymeren ab, das sich als das Monoacetat des Polymeren IV erweist und im NMR-Spektrum ein zusätzliches Signal bei $\delta = 2{,}25$ ppm zeigt.

### Beispiel 2

Analog Beispiel 1, Methode A, setzt man eine Suspension von 100 Gew.-Teilen Dimethylformamid, 50 Gew.-Teilen Pyridin und 10,72 Gew.-Teilen Naphthalintetracarbonsäuredianhydrid mit einer Lösung von 5,25 Gew.-Teilen Bis-(3-aminopropyl)-amin in 50 Gew.-Teilen Pyridin um. Man erhält 14,9 Gew.-Teile eines Polymeren V.

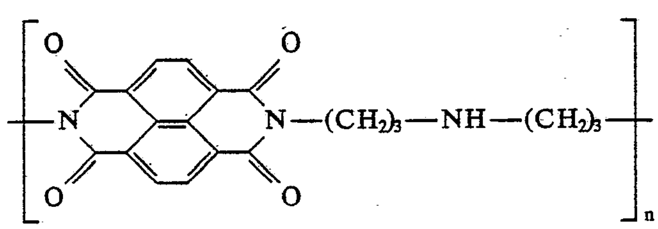

(V)

### Beispiel 3

Analog Beispiel 1, Methode A, setzt man eine Suspension von 100 Gew.-Teilen Dimethylformamid,

50 Gew.-Teilen Pyridin und 10,72 Gew.-Teilen Naphthalintetracarbonsäuredianhydrid mit einer Lösung von 8,16 Gew.-Teilen Butandiol-(1,4)-bis-(3-aminopropylether) um. Man erhält 15 Gew.-Teile eines Polymeren VI.

| | | | | |
|---|---|---|---|---|
| Berechnet für VI: | C 66,05 | H 5,55 | N 6,42 | O 22,00 |
| Gef.: | C 65,0 | H 5,8 | N 6,2 | O 22,6 |

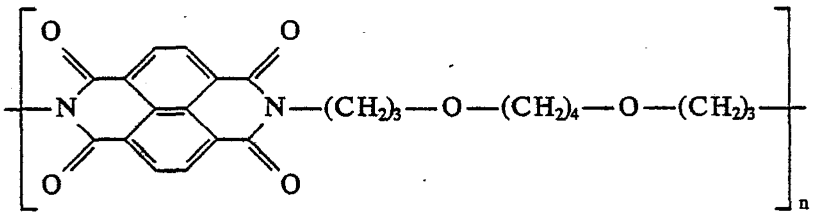
(VI)

Setzt man die Ausgangsverbindungen nach der Methode 1 B um, so erhält man ein identisches Polymeres.

Spez. Leitfähigkeit: 1,35 · $10^{-3}\Omega^{-1}$ $cm^{-1}$ (Mikrowellenmessung, Meßfrequenz 9 GHz).

Beispiel 4

Analog Beispiel 1, Methode A, setzt man mit 5,8 Gew.-Teilen Methyl-bis-(3-aminopropyl)-amin um. Man erhält 14,8 Gew.-Teile eines Polymeren mit der idealisierten Struktur VII.

| | | | | |
|---|---|---|---|---|
| Berechnet für VII: | C 66,84 | H 5,08 | N 11,14 | O 16,96 |
| Gef.: | C 65,1 | H 5,2 | N 10,7 | O 17,9 |

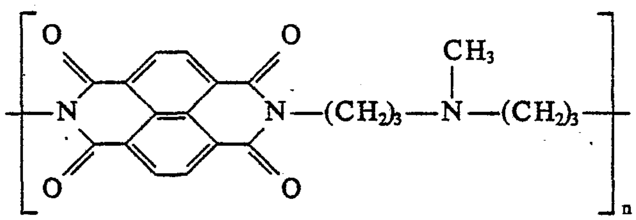
(VII)

Die spezifische Leitfähigkeit beträgt 4,2 · $10^{-8}$ $\Omega^{-1}$ $cm^{-1}$ (Gleichstrom, Meßspannung 100 V).

Beispiele 5–22

Die folgenden Di- und Polyamine wurden Analog Beispiel 1, Methode A, mit Naphthalintetracarbonsäuredianhydrid umgesetzt:

| Beispiel | | IR [$cm^{-1}$] | NMR [$\delta$/ppm] oder Analyse | | | | | |
|---|---|---|---|---|---|---|---|---|
| 5 | $H_2N-(CH_2-CH_2-NH)_x-CH_2-CH_2-NH_2$<br>x = 2 | 1700/1660 | 9,0 (4 H), 4,85 (4 H), 4,0 (8 H) | | | | | |
| 6 | x = 3 | 1700/1655 | Ber.<br>Gef. | C 62,7<br>C 59,9 | H 5,52<br>H 5,6 | N 16,64<br>N 15,3 | O 15,21<br>O 16,5 |
| 7 | x = 4 | 1700/1660 | | | | | |
| 8[1]) | $H_2N-(CH_2)_3-N-(CH_2)_3-NH_2$<br>\|<br>$(CH_2)_3-N(CH_3)_2$ | 1710/1665 | Ber. | C 66,80<br>C 66,25 | H 6,30<br>H 6,45 | N 12,48<br>N 12,65 | O 14,26<br>O 14,65 |
| 9 | $H_2N-(CH_2)_3-N-(CH_2)_3-NH_2$<br>\|<br>$(CH_2)_3-OC_4H_9$ | 1705/1660 | 9,0 (4 H), 4,6 (4 H), 3,7 (10 H), 2,5 (6 H),<br>1,6 (4 H), 0,95 (3 H) | | | | |
| 10[2]) | $H_2N-(CH_2)_2-CH-(CH_2)_3-NH_2$<br>\|<br>$N(CH_3)_2$ | 1705/1660 | 9,0 (4 H), 4,55 (4 H), 3,65 (1 H), 3,2 (6 H)<br>2,45 (2 H), 2,15 (4 H) | | | | |
| 11 | $H_2N-(CH_2)_3-N-(CH_2)_3-NH_2$<br>\|<br>$C_4H_9$ | 1705/1660 | Ber.<br>Gef. | C 68,65<br>C 67,5 | H 6,01<br>H 6,15 | N 10,02<br>N 10,20 | O 15,26<br>O 15,15 |
| 12 | $H_2N-(CH_2)_3-O-(CH_2)_2-O(CH_2)_3-NH_2$<br>(nach Methode 1 B) | 1700/1660 | Ber.<br>Gef. | C 64,5<br>C 64,2 | H 4,92<br>H 5,05 | N 6,85<br>N 6,6 | O 23,5<br>O 24,1 |
| 13 | $H_2N-CH_2-CH_2-S-CH_2-CH_2-NH_2$ | 1700/1660 | | | | | |
| 14 | $(H_2N-CH_2-CH_2-S-C_4H_8)_2O$ | 1705/1665 | | | | | |
| 15 | $H_2N-$ 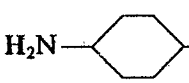 $-NH-(CH_2)_3-NH_2$ | 1700/1660 | | | | | |

Tabelle (Fortsetzung)

| Beispiel | | IR [$cm^{-1}$] | NMR [$\delta$/ppm] oder Analyse |
|---|---|---|---|
| 16 | 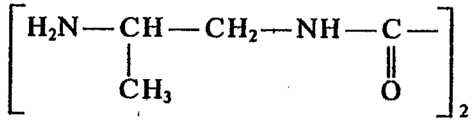 | 1700/1660 | Ber. C 60,8 H 4,17 N 12,9 O 22,1<br>Gef. C 59,8 H 4,6 N 12,2 O 23,7 |
| 17 | 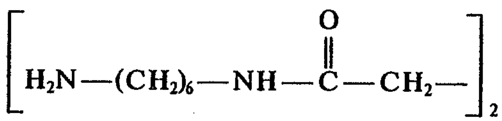 | | 9,0 (4 H), 4,4 (4 H), 3,6 (4 H), 2,8 (8 H),<br>1,4–2,2 (8 H) |
| 18 | $[H_2N—(CH_2)_3—O—(CH_2)_2—]_2O$ | 1705/1660 | Ber. C 63,7 H 5,35 N 6,19 O 24,78<br>Gef. C 63,5 H 5,9 N 6,15 O 24,75 |
| 19 | $[H_2N—(CH_2)_3—O—CH_2—]_2C(CH_3)_2$ | 1700/1660 | Ber. C 66,66 H 5,81 N 6,22 O 21,31<br>Gef. C 66,55 H 5,85 N 6,25 O 22,0 |
| 20[3]) | $[H_2N—(CH_2)_3—NH—CH_2—]_2$ | 1705/1660 | |
| 21 | $H_2N—(CH_2)_4—NH—(CH_2)_4—NH_2$ | 1700/1660 | Ber. C 66,8 H 5,06 N 11,14 O 16,97<br>Gef. C 65,1 H 5,55 N 10,55 O 17,6 |
| 22 | 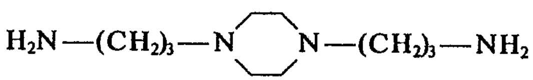 | 1705/1665 | |

[1]) Dunkelleitfähigkeit: $1{,}0 \cdot 10^{-3}\ \Omega^{-1}\ cm^{-1}$ (Mikrowellenmessung bei 9 GHz); steigt nach 20 Minuten Belichtung mit einer Xenonhochdrucklampe auf $1{,}8 \cdot 10^{-3}\ \Omega^{-1}\ cm^{-1}$ (Mikrowellenmessung bei 9 GHz).
Das Bis-acetat (Umsetzungsprodukt mit 2 Mol Essigsäure) zeigt eine Dunkelleitfähigkeit von $1{,}3 \cdot 10^{-4}\ \Omega^{-1}\ cm^{-1}$.

[2]) Spezifische Leitfähigkeit: $3{,}2 \cdot 10^{-3}\ \Omega^{-1}\ cm^{-1}$ (Mikrowellenmessung bei 9 GHz).

[3]) Vom Polyimid 20 wurde ein Film auf einem Aluminium-Blech hergestellt. Der Film zeigt bei 25°C eine spezifische Leitfähigkeit von $10^{-8}\ \Omega^{-1}\ cm^{-1}$, die bei 150°C auf $10^{-5}\ \Omega^{-1}\ cm^{-1}$ ansteigt (Meßspannung 1 V, Gleichstrom). Der Oberflächenleitwert 1/RoA nach DIN 53 482/IEC 167 beträgt bei 25°C $5 \times 10^{-7}\ \Omega^{-1}$ und steigt beim Belichten mit einer Quecksilberhochdrucklampe auf $10^{-5}\ \Omega^{-1}$ an.

## Beispiel 23

Analog Beispiel 1, Methode A, setzt man 14,5 Gew.-Teile Methyl-bis-(3-aminopropyl)-amin mit 30,3 Gew.-Teilen 2-Chlornaphthalintetracarbonsäuredianhydrid um. Man erhält 39,5 Gew.-Teile des Polymeren XXIII.

Analyse

| | | | | |
|---|---|---|---|---|
| Ber. | C 61,26 | H 4,41 | N 10,20 | Cl 8,61 |
| Gef. | C 60,9 | H 4,5 | N 10,4 | Cl 8,9 |

IR (KBr): 1705/1668 $cm^{-1}$($\nu_{co}$)

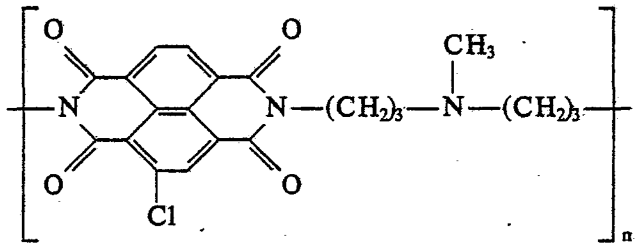

(XXIII)

## Beispiel 24

Analog Beispiel 1, Methode A, setzt man 14,5 Gew.-Teile Methyl-bis-(3-aminopropyl)-amin mit 31,3 Gew.-Teilen 2-Nitronaphthalintetracarbonsäuredianhydrid um. Man erhält 43,2 Gew.-Teile des Polymeren XXIV.

Analyse

| | | | |
|---|---|---|---|
| Ber. | C 59,71 | H 4,30 | N 13,27 |
| Gef. | C 60,1 | H 4,4 | N 13,7 |

IR (KBr): 1708/1660 $cm^{-1}$($\nu_{co}$)

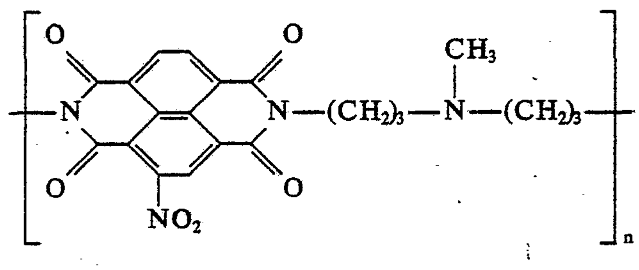

(XXIV)

## Beispiel 25

Analog Beispiel 1, Methode A, setzt man 14,5 Gew.-Teile Methyl-bis-(3-aminopropyl)-amin mit 31,2 Gew.-Teilen Naphthalinpentacarbonsäuredianhydrid um. Man erhält 38,2 Gew.-Teile des Polymeren XXV.

Analyse

| | | | |
|---|---|---|---|
| Ber. | C 62,70 | H 4,55 | N 9,97 |
| Gef. | C 63,0 | H 4,7 | N 10,2 |

IR (KBr): 1704/1658 $cm^{-1}$ ($\nu_{co}$)

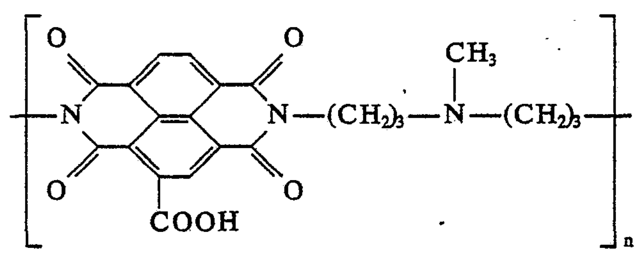

(XXV)

Beispiel 26

Analog Beispiel 1, Methode B, setzt man 13,1 Gew.-Teile Bis-(3-aminopropyl)-amin mit 40,6 Gew.-Teilen Tetrachlor-naphthalintetracarbonsäuredianhydrid um. Man erhält 52,5 Gew.-Teile des Polymeren XXVI.

Analyse

| | | | | |
|---|---|---|---|---|
| Ber. | C 47,93 | H 2,62 | N 8,39 | Cl 28,30 |
| Gef. | C 47,6 | H 2,5 | N 8,7 | Cl 27,9 |

IR (KBr): 1712/1664 $cm^{-1}$ ($\nu_{co}$)

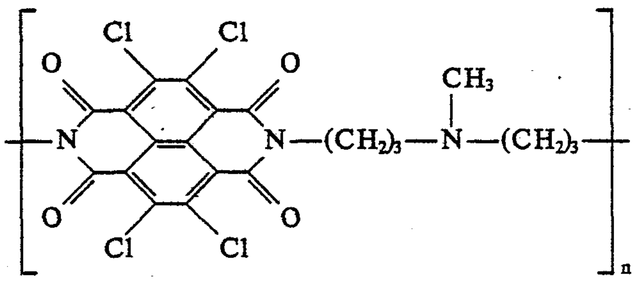

(XXVI)

## Patentansprüche

1. Cyclische Polyimide der Formel I

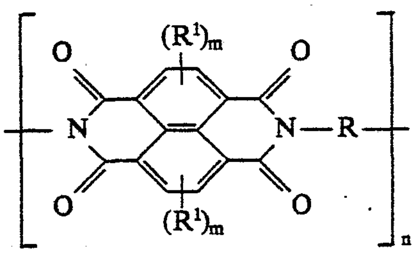

(I)

worin

R ein zweiwertiger aliphatischer Rest ist, der eine Elektronendonatorfunktion enthält,
$R^1$ Wasserstoff, Halogen, $-SO_3H$, $-CN$, $-COOR^2$, $-N(R^3)_2$, $-OR^4$, $-NO_2$
$R^2$, $R^3$, $R^4$ Wasserstoff oder $C_1-C_6$-Alkyl und
n eine ganze Zahl von 2 bis 1000 und
m 1 oder 2 bedeuten.

2. Verfahren zur Herstellung cyclischer Polyimide nach Anspruch 1, dadurch gekennzeichnet, daß man ein Naphthalin-1,4,5,8-tetracarbonsäuredianhydrid oder eine Naphthalin-1,4,5,8-tetracarbonsäure mit einem Diamin, das den Rest R einschließlich der daran gebundenen Stickstoffatome liefert, gegebenenfalls in einem organischen Lösungsmittel umsetzt.

3. Verwendung der cyclischen Polyimide gemäß Anspruch 1 als elektrische Halbleiter oder Photoleiter.

## Claims

1. Cyclic polyimides of the formula I

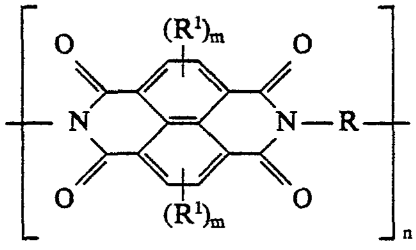

(I)

wherein

R denotes a divalent aliphatic group containing an electron donor group,
$R^1$ denotes hydrogen, halogen, $-SO_3H$, $-CN$, $-COOR^2$, $-N(R^3)_2$, $-OR^4$, or $-NO_2$,
$R^2$, $R^3$ and $R^4$ denote hydrogen or $C_1-C_6$ alkyl and
n denotes an integer of from 2 to 1000 and
m denotes 1 or 2.

2. Process for the preparation of cyclic polyimides according to claim 1, characterizedin that a naphthalene-1,4,5,8-tetracarboxylic acid dianhydride or a naphthalene-1,4,5,8-tetracarboxylic acid is reacted with a diamine which yields the group R including the nitrogen atoms attached thereto, optionally in an organic solvent.

3. Use of the cyclic polyimides according to claim 1 as electrical semiconductors or photoconductors.

## Revendications

1. Polyimides cycliques de formule (I):

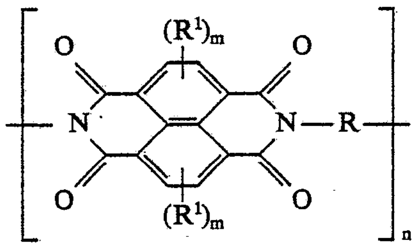

(I)

dans laquelle

R est un radical aliphatique divalent, qui contient une fonction pouvant donner des électrons,
$R^1$ est un atome d'hydrogène ou d'halogène ou représente $-SO_3H$, $-CN$, $-COOR^2$, $-N(R^3)_2$, $-OR^4$ ou $-NO_2$,
$R^2$, $R^3$ et $R^4$ sont chacun un atome d'hydrogène ou un groupe alkyle ayant 1 à 6 atomes de carbone, et
n est un nombre entier valant 2 à 1000 et
m vaut 1 ou 2.

2. Procédé pour produire des polyimides cycliques selon la revendication 1, caractérisé en ce qu'on fait réagir, éventuellement dans un solvant organique, un dianhydride d'acide naphtalène-1,4,5,8-tétracarboxylique ou un acide naphtalène-1,4,5,8-tétracarboxylique avec une diamine qui fournit le radical R ainsi que les atomes d'azote qui y sont rattachés.

3. Utilisation des polyimides cycliques selon la revendication 1 comme semi-conducteurs électriques ou photoconducteurs électriques.